# EUROPÄISCHE PATENTANMELDUNG

(11) **EP 1 696 442 A2**
(43) Veröffentlichungstag der Anmeldung: **30.08.2006**
(21) Anmeldenummer: 06003429.5
(22) Anmeldetag: 20.02.2006
(51) Int. Cl.: G11C 16/04

(54) **Halbleiterschaltungsvorrichtung und Verfahren zum Betreiben der Halbleiterschaltungsvorrichtung**

(30) Priorität: 25.02.2005 US 66731; 24.05.2005 DE 102005023911
(71) Anmelder: Infineon Technologies AG, 81669 München (DE)
(72) Erfinder: Gratz, Achim, 01109 Dresden (DE); Röhrich, Mayk, 01099 Dresden (DE)
(74) Vertreter: Epping - Hermann - Fischer

(57) **Zusammenfassung**

Eine Halbleiterschaltungsvorrichtung umfasst ein programmierbares Konfigurationselement (9) mit zwei, zwischen zwei Logikpegelknoten (Logic-VDD, Logic-VSS), in Reihe gekoppelten nichtflüchtigen Speicherzellen (1, 2) mit jeweils einem Strompfad zwischen einem ersten Anschluss (11, 21) und einem zweiten Anschluss (12, 22), die in einen ersten Zustand, in dem der Strompfad leitend ist, oder in einen zweiten Zustand, in dem der Strompfad nichtleitend ist, konfigurierbar sind. Der Ausgang (3) zwischen den Speicherzellen (1, 2) ist mit dem ersten Logikpegelknoten gekoppelt (Logic-VDD), wenn sich die erste nichtflüchtige Speicherzelle (1) im ersten Zustand befindet. Der Ausgang (3) ist mit dem zweiten Logikpegelknoten (Logic-VSS) gekoppelt, wenn sich die zweite nichtflüchtige Speicherzelle (2) im ersten Zustand befindet. Die Halbleiterschaltungsvorrichtung ist derartig betreibbar, dass sich die erste nichtflüchtige Speicherzelle (1) nicht gleichzeitig mit der zweiten nichtflüchtigen Speicherzelle (2) im ersten Zustand befindet.

## Beschreibung

Die vorliegende Erfindung betrifft eine Halbleiterschaltungsvorrichtung und ein Verfahren zum Betreiben der Halbleiterschaltungsvorrichtung.

Die Miniaturisierung tragbarer Geräte erfordert hochintegrierte Logikchips. Viele dieser Anwendungen verwenden einen nichtflüchtigen Speicher zum Speichern von Informationen, die sehr wenige Bytes aufweisen. Diese Informationen können Konfigurationsparameter, zum Beispiel zur Einstellung eines analogen Schaltsystems oder zur Anpassung für eine spezielle Anwendung oder zur Anpassung an äußere Bedingungen, umfassen. Alternativ können diese Informationen Einzelinformationen wie eine Geräteseriennummer oder eine Identifikationsnummer, die als so genannte Personalisierungsparameter bezeichnet werden, umfassen. Typische Anwendungen können einige Bytes, z.B. 10 Bytes bis etwa 1 Kilobyte, benötigen, um die Personalisierungsparameter und/oder die Konfigurationsparameter zu speichern.

Ein Beispiel für die Verwendung eines derartigen nichtflüchtigen Speichers in einer miniaturisierten Anwendung ist die individuelle Anpassung der Filterparameter eines Hörgeräts durch den Hörgeräte-Akustiker an den Träger oder die Trägerin des Geräts oder das Speichern von Lautstärkeparämetern in einem Hörgerät, bevor dieses abgeschaltet wird.

Die Personalisierungsparameter und insbesondere die Konfigurationsparameter können veränderbar sein. Die Konfigurationsparameter werden üblicherweise während des normalen Betriebsmodus nicht verändert, lediglich vor dem Ausschalten oder beim Wechsel von dem normalen Betriebsmodus in einen Ruhemodus. Im Besonderen benötigen batteriebetriebene tragbare Anwendungen die Personalisierungsparameter und speziell die Konfigurationsparameter, um den Ruhemodus oder ein teilweises Stromabschalten ohne Datenverlust zu überstehen, und um ein erneutes Anpassen und Konfigurieren der Anwendung zu vermeiden.

Herkömmliche Anwendungen umfassen einen eingebauten nichtflüchtigen Speicher, der durch einen Microcontroller gelesen und programmiert wird, um die Personalisierungs- und Konfigurationsparameter zu speichern.

Alternativ kann die Anwendung ein nichtflüchtiges Speichermodul umfassen, das beim Initialisieren der Schaltungen über eine interne Steuerung oder eine Zustandssteuerung, die auch als "state machine" bekannt ist, in einen flüchtigen Speicher, den Arbeitsspeicher, ausgelesen wird. Das Hinzufügen eines nichtflüchtigen Speichermoduls zu einem Chip, von dem nur einige wenige Bytes des Speichers verwendet werden, ist sehr ineffizient. Herkömmliche Speichermodule, die das Speichern von viel mehr Daten ermöglichen, sind überdimensioniert und benötigen viel Platz.

Die Zeitverzögerung, die beim Initialisieren durch das Auslesen eines solchen nichtflüchtigen Speichers in den flüchtigen Speicher auftritt, führt zu einem unkomfortablen Betrieb.

Weitere Nachteile des nichtflüchtigen Speichermoduls oder des eingebauten Speichers sind ihr Energie- und Platzbedarf.

Herkömmliche programmierbare Elemente für Logiktechnologien sind nicht hinsichtlich der Speicherfähigkeit über einen langen Zeitraum optimiert und sind auch schwierig zu skalieren. Das Verfahren zum Programmieren oder Löschen derartiger programmierbarer Elemente ist sehr kompliziert.

Programmierbare Anordnungen wie so genannte Field Programmable Gate Arrays, kurz FPGA, sind nicht für kleine Speicher geeignet. Sie sind nicht für Betrieb mit niedrigen Spannungen und geringer Versorgungsleistung optimiert.

Es stellt sich die Aufgabe, eine nicht-flüchtige Speicheranordnung mit Speicherzellen und ein Verfahren zu deren Betreiben anzugeben, die zur Speicherung kleiner Datenmengen derart geeignet ist, dass der Energie- und Platzbedarf der zu speichernden Datenmenge angepasst ist.

Die Aufgabe wird durch die in den nebengeordneten Patentansprüchen angegebenen Maßnahmen gelöst.

Es ist eine Halbleiterschaltung mit einem programmierbaren Konfigurationselement vorgesehen, welches umfasst eine erste nicht-flüchtige Speicherzelle mit einem Strompfad zwischen einem ersten Anschluss und einem zweiten Anschluss, die in einem ersten Zustand, in dem der Strompfad im Wesentlichen leitend ist oder in einem zweiten Zustand, in dem der Strompfad im Wesentlichen nichtleitend ist, konfigurierbar ist. Des Weiteren umfasst das programmierbare Konfigurationselement eine zweite nicht-flüchtige Speicherzelle mit einem Strompfad zwischen einem ersten Anschluss und einem zweiten Anschluss, die in den ersten Zustand oder in den zweiten Zustand konfigurierbar ist, wobei der zweite Anschluss der ersten nicht-flüchtigen Speicherzelle mit dem ersten Anschluss der zweiten nicht-flüchtigen Speicherzelle gekoppelt ist. Ein erster Logikpegelknoten ist mit dem ersten Anschluss der ersten nicht-flüchtigen Speicherzelle gekoppelt. Ein zweiter Logikpegelknoten ist mit dem zweiten Anschluss der zweiten nicht-flüchtigen Speicherzelle gekoppelt. Ein Ausgang ist mit dem zweiten Anschluss der ersten nicht-flüchtigen Speicherzelle und dem ersten Anschluss der zweiten nicht-flüchtigen Speicherzelle gekoppelt, wobei der Ausgang mit dem ersten Logikpegelknoten gekoppelt ist, wenn sich die erste nichtflüchtige Speicherzelle im ersten Zustand befindet und wobei der Ausgang mit dem zweiten Logikpegelknoten gekoppelt ist, wenn sich die zweite nicht-flüchtige Speicherzelle im ersten Zustand befindet und wobei die Halbleiterschaltungsvorrichtung derartig betreibbar ist, dass sich die erste nichtflüchtige Speicherzelle (1) nicht gleichzeitig mit der zweiten nichtflüchtigen Speicherzelle (2) im zweiten Zustand befindet.

Mit den programmierbaren Konfigurationselementen lassen sich z.B. Personalisierungs- oder Konfigurationsinformationen über einen langen Zeitraum speichern. In Abhängigkeit von den dafür vorgesehenen Bits werden nur so viele programmierbare Konfigurationselemente vorgesehen, wie benötigt werden, sodass der Platz- und Energiebedarf hinsichtlich der Anforderung optimal dimensioniert ist.

Jedes programmierbare Konfigurationselement ist ausgebildet, einen ersten oder einen zweiten Binärwert zu repräsentieren.

Vorzugsweise umfassen sowohl die erste als auch die zweite Speicherzelle je einen Floating-Gate-Transistor, die sich dadurch auszeichnen, dass sie Informationen über einen langen Zeitraum speichern können. In anderen Ausführungsformen können auch andere nicht-flüchtige Speicherelemente verwendet werden.

Das im programmierbaren Konfigurationselement gespeicherter Bit kann einen ersten Binärwert oder einen zweiten Binärwert aufweisen. Wenn der erste Floating-Gate-Transistor leitend ist und der zweite nicht, ist der Ausgang mit dem ersten Logikpegelknoten gekoppelt, und es wird der erste Binärwert repräsentiert. Wenn der zweite Floating-Gate-Transistor leitend ist und der erste nicht, ist der Ausgang mit dem zweiten Logikpegelknoten gekoppelt, und es wird der zweite Binärwert repräsentiert. Wenn an die Logikpegelknoten die entsprechenden Logikpegel angelegt werden, sind die Ausgangssignale direkt kompatibel mit logischen Signalen, was die deren weitere Verarbeitung erleichtert. Das Potenzial des ersten Logikpegelknotens am Ausgang stellt den ersten Binärwert, z.B. eine logische "1", dar. Das Potenzial am Ausgang, das gleich oder nahezu gleich dem Potenzial des zweiten Logikpegelknotens ist, stellt den zweiten Binärwert, z.B. eine logische "0", dar.

Zur Programmierung des programmierbaren Konfigurationselements ist eine Programmierschaltung vorgesehen, die derart ausgebildet ist, dass eine erste vorgegebene elektrische Ladung im ersten Floating Gate positioniert wird und eine geringere Ladung als eine vorgegebene zweite elektrische Ladung im zweiten Floating Gate positioniert wird. Auf diese Weise werden im programmierbaren Konfigurationselement auf einfache Weise Zustände konfiguriert.

Die beschriebene Halbleiterschaltungsvorrichtung weist keine herkömmliche Speicherzellenanordnung und die dazugehörige Steuervorrichtung auf. Deshalb hängt die Größe der Halbleiterschaltungsvorrichtung nur von der Anzahl der programmierbaren Konfigurationselemente ab. Obwohl jedes programmierbare Konfigurationselement zwei Transistoren umfasst, benötigt die sich ergebende Halbleiterschaltungsvorrichtung im Fall, dass nur wenige Bytes gespeichert werden, weniger Raum als eine herkömmliche Speicherzellenanordnung einschließlich ihrer Steuervorrichtung zum Programmieren und Lesen aller Speicherzellen. Deshalb verringert sich auch der Organisationsaufwand zum Betrieb der Halbleiterschaltungsvorrichtung.

Der Floating-Gate-Transistor ist nichtleitend, wenn eine vorgegebene elektrische Ladung, die Elektronen umfasst, im Floating Gate positioniert ist. Wenn eine geringere Ladung als die vorgegebene elektrische Ladung, insbesondere keine oder fast keine Elektronen im Floating Gate positioniert sind, ist der Floating-Gate-Transistor leitend. Die vorgegebene erste oder zweite Ladung kann durch Injizieren und Speichern von Elektronen in das erste bzw. zweite Floating Gate eingebracht werden. Um eine geringere Ladung als die vorgegebene erste oder zweite Ladung zu positionieren, können die Elektronen entfernt werden. Somit ist entweder der erste Floating-Gate-Transistor leitend, während der zweite Floating-Gate-Transistor nichtleitend ist, um den ersten Binärwert darzustellen oder es ist der zweite Floating-Gate-Transistor leitend, während der erste Floating-Gate-Transistor nichtleitend ist, um den zweiten Binärwert darzustellen.

Zum Lesen des Bits, wird ist eine Lesespannung über den Logikpegelknoten angelegt und detektiert, welche Spannung am Ausgang anliegt. Wenn der erste Floating-Gate-Transistor leitend ist und der zweite nicht, wird das Potenzial des Ausgangs auf das des ersten Logikpegelknotens gezogen. Die detektierte Spannung repräsentiert den ersten Binärwert. Wenn der zweite Floating-Gate-Transistor leitend ist und erste nicht, wird das Potenzial des Ausgangs auf den des zweiten Logikpegelknotens gezogen. Die resultierende Spannung am Ausgang repräsentiert den zweiten Binärwert. Da während des normalen Betriebs nur einer der beiden Floating-Gate-Transistoren leitend ist, ist stets das gespeicherte Bit detektierbar.

Beim Anlegen der Lesespannung ist die Ausgangsspannung sofort und ständig verfügbar, ohne einen Ruhestrom abzuleiten. Während des normalen Betriebsmodus werden weder gesonderte Auslesevorgänge noch weitere Auslesesignale benötigt. Die vollständige Funktion der Halbleiterschaltungsvorrichtung ist bei einer niedrigen Versorgungsspannung mit niedriger Leistungsaufnahme verfügbar.

Eine Programmierdatenleitung ist mit der Programmierschaltung verbunden und stellt Signale bereit, in Abhängigkeit derer der erste oder zweite Binärwert programmiert wird. Die Programmierschaltung stellt ein Datensignal und ein inverses Datensignal bereit, die an ein Steuergate und ein Tunnelelement des ersten Floating-Gate-Transistors gekoppelt sind, und, mit vertauschten Anschlüssen, an den zweiten Floating-Gate-Transistor gekoppelt sind. Diese Verdrahtung bedingt, dass an den Floating-Gate-Transistoren des programmierbaren Konfigurationselements zu einander inverse Spannungen zum Programmieren anliegen, was zur Folge hat, dass nur einer der Floating-Gate-Transistoren leitend wird. Somit fließt kein zwischen den Logikpegelkonten kein Strom, was den Energieverbrauch der Schaltungsanordnung begrenzt.

Das Datensignal und das inverse Datensignal werden durch einen Pegelumsetzer bereitgestellt. Der Pegelumsetzer stellt das Datensignal in Abhängigkeit der Datensignalleitung und einer Leseprogrammierleitung bereit, wobei die bereitgestellten Signale davon abhängen, ob gelesen oder programmiert werden soll. Durch den Pegelumsetzer werden zu speichernde Daten mit dem programmierbaren Konfigurationselement in einfacher Weise gekoppelt, ohne die zum Lesen und zur Versorgung benötigte Spannung an den Logikpegelknoten zu entkoppeln.

Um mehr als ein Bit in der Halbleiterschaltungsvorrichtung zu speichern, ist es von Vorteil, dass diese eine Vielzahl von programmierbaren Konfigurationselementen aufweist, von denen jedes mit einem Pegelumsetzer verbunden ist.

Zur Verringerung des Platzbedarfs der Halbleiterschaltungsvorrichtung ist eine einfachere Verdrahtung zwischen den ersten Pegelumsetzern und den programmierbaren Konfigurationselementen vorgesehen. Ein zweiter Pegelumsetzer ist in diesen Fall an jedes programmierbare Konfigurationselement gekoppelt und ermöglicht in Wechselwirkung mit dem dazugehörigen ersten Pegelumsetzer die Programmierung der programmierbaren Konfigurationselemente.

Das Verfahren zum Betreiben der Halbleiterschaltungsvorrichtung umfasst das Programmieren eines Bits mit einem ersten Binärwert durch Anlegen von Schreibspannungen an die erste und zweite nicht-flüchtige Speicherzelle, sodass die erste nicht-flüchtige Speicherzelle leitend wird und die zweite nicht-flüchtige Speicherzelle nichtleitend wird oder mit einem zweiten Binärwert, sodass die erste nicht-flüchtige Speicherzelle nichtleitend wird und die zweite nicht-flüchtige Speicherzelle leitend wird und ein Lesen des programmierbaren Bits am Ausgang. Auf diese Weise wird ein Bit in einfacher Weise programmiert.

Beim Lesen des Bits wird durch Anlegung von Lesespannungen an das programmierbare Konfigurationselement und durch Detektieren dessen Ausgangs bestimmt, ob der erste Binärwert gespeichert wird, in diesem Fall liegt eine erste Ausgangsspannung am Ausgang an, oder ob der zweite Binärwert gespeichert wird, in diesem Fall liegt eine zweite Ausgangsspannung am Ausgang an. Diese Ausgangsspannungen sind vorteilhafterweise kompatibel mit weiterverarbeitbaren Logiksignalen. Weil die Lesespannungen gleichzeitig die Versorgungsspannungen der programmierbaren Konfigurationselemente sind, liegt unmittelbar nach der Initialisierung der gespeicherte Wert am Ausgang an.

In einem ersten Ausführungsbeispiel des Verfahrens werden der erste und der zweite Floating-Gate-Transistor zur gleichen Zeit programmiert, indem eine erste Schreibspannung an den ersten Floating-Gate-Transistor angelegt wird, während eine zweite Schreibspannung, die zur ersten Schreibspannung invers ist, an den zweiten Floating-Gate-Transistor angelegt wird. Zur Programmierung des anderen Binärwerts werden die erste und zweite Schreibspannung in umgekehrter Weise an die Floating-Gate-Transistoren angelegt. Als Ergebnis werden der erste und zweite Floating-Gate-Transistor zur gleichen Zeit programmiert, um während des normalen Betriebsmodus entweder den ersten oder zweiten Binärwert zu repräsentieren. Diese Programmierung ist zeitsparend.

In einem zweiten Ausführungsbeispiel des Verfahrens umfasst das Programmieren der Bits zwei Schritte. Im ersten Schritt werden die Spannungen angelegt, um den ersten Binärwert zu repräsentieren. Im zweiten Schritt werden die Spannungen angelegt, um den zweiten Binärwert zu repräsentieren. Alternativ kann zuerst der zweite und dann der erste Binärwert programmiert werden. Beim Programmieren mehrerer programmierbarer Konfigurationselemente werden mit diesem Verfahren zunächst die programmierbaren Konfigurationselemente programmiert, mit denen erste Binärwerte repräsentiert werden sollen und dann die anderen programmierbaren Konfigurationselemente, die den zweiten Binärwert repräsentieren sollen. Natürlich ist auch die umgekehrte Reihenfolge denkbar. Diese Programmierung ist für eines der Ausführungsbeispiele, das besonders Platz sparend ist, geeignet.

Nachfolgend wird die Erfindung unter Bezugnahme auf die Zeichnung anhand von Ausführungsbeispielen erklärt.

Es zeigen:
Figur 1 ein Blockdiagramm mit einem programmierbaren Konfigurationselement;
Figur 2 ein erstes Ausführungsbeispiel einer Halbleiterspeichervorrichtung, die mehrere programmierbare Konfigurationselemente umfasst; und
Figur 3 ein zweites Ausführungsbeispiel einer Halbleiterspeichervorrichtung, die mehrere programmierbare Konfigurationselemente umfasst.

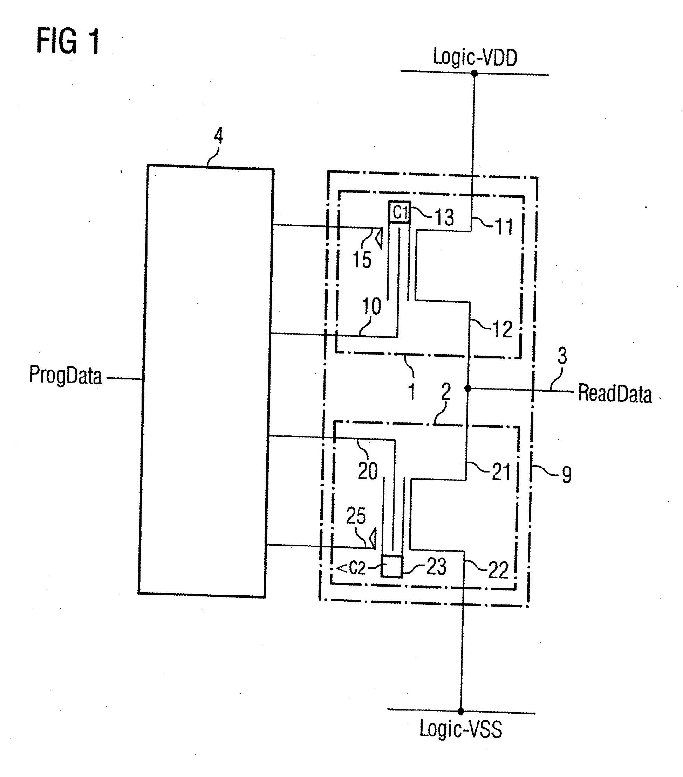

Figur 1 zeigt ein Blockdiagramm mit einem programmierbaren Konfigurationselement 9, das einen ersten Floating-Gate-Transistor 1 und einen zweiten Floating-Gate-Transistor 2 umfasst. Der erste Floating-Gate-Transistor 1 und der zweite Floating-Gate-Transistor 2 sind in Reihe geschaltet. Der gemeinsame Schaltungsknoten ist als Ausgang 3 vorgesehen. Der erste Floating-Gate-Transistor 1 umfasst ein erstes Floating Gate 13, um darin Elektronen zu speichern. Der erste Floating-Gate-Transistor 1 umfasst ferner ein erstes Steuergate 10 und ein erstes Tunnelelement 15. Der erste Floating-Gate-Transistor 1 hat einen ersten Anschluss 11 und einen zweite Anschluss 12. In der gleichen Weise wie der erste Floating-Gate-Transistor 1 umfasst der zweite Floating-Gate-Transistor 2 einen ersten Anschluss 21, einen zweiten Anschluss 22, ein zweites Floating Gate 23, ein zweites Steuergate 20 und ein zweites Tunnelelement 25.

Der zweite Anschluss 12 des ersten Floating-Gate-Transistors 1 ist mit dem ersten Anschluss 21 des zweiten Floating-Gate-Transistors 2 verbunden. Der Ausgang 3 ist mit dem zweiten Anschluss 12 des ersten Floating-Gate-Transistors 1 gekoppelt. Der erste Anschluss 11 des ersten Floating-Gate-Transistors 1 ist mit der ersten Leitung Logic-VDD gekoppelt, um eine erste Lesespannung anzulegen, die zur Leistungsversorgung dient. Der zweite Anschluss 22 des zweiten Floating-Gate-Transistors 2 ist mit der zweiten Leitung Logic-VSS gekoppelt, um eine zweite Lesespannung anzulegen.

Eine Programmierschaltung 4 ist mit dem ersten Floating-Gate-Transistor 1 und dem zweiten Floating-Gate-Transistor 2 gekoppelt. Wenn die Programmierschaltung 4 aktiviert wird, kann ein Bit, das entweder einen ersten Binärwert oder einen zweiten Binärwert verkörpert, im programmierbaren Konfigurationselement 9 programmiert und gespeichert werden.

Während eines normalen Betriebsmodus erlaubt das programmierbare Konfigurationselement 9, durch Anlegen der ersten und der zweiten Lesespannung zu detektieren, ob der erste Binärwert gespeichert ist, indem am Ausgang 3 eine erste Ausgangsspannung festgestellt wird, oder ob der zweite Binärwert gespeichert ist, indem am Ausgang 3 eine zweite Ausgangsspannung festgestellt wird.

Typischerweise umfasst der erste und der zweite Floating-Gate-Transistor 1, 2 eine Drain-Elektrode, die der erste Anschluss 11, 21 des ersten oder zweiten Floating-Gate-Transistors 1, 2 sein kann, und eine Source-Elektrode, die der zweite Anschluss 12, 22 des ersten oder zweiten Floating-Gate-Transistors 1, 2 sein kann.

Jeder erste und zweite Floating-Gate-Transistor 1, 2 umfasst ein leitendes Gate (z.B. Polysilizium), das von einem Isolator umgeben ist. Im ersten oder zweiten Floating Gate 13, 23 kann eine elektrische Ladung, insbesondere Elektronen, gespeichert werden.

Elektronen werden in das Floating Gate 13, 23 injiziert, indem zwischen dem Tunnelelement 15, 25 und dem Steuergate 10, 20 eine negative Spannung angelegt wird. Die Elektronen werden aus dem Floating Gate entfernt, indem zwischen dem Tunnelelement 15, 25 und dem Steuergate 10, 20 eine positive Spannung angelegt wird. Andere Programmier- und Löschtechniken können verwendet werden, wenn andere Konfigurationen nichtflüchtiger Speicherzellen verwendet werden.

Ein Zustand des Floating-Gate-Transistors hängt von der Ladung beziehungsweise der Menge der Ladung ab, die im Floating Gate platziert ist. Wenn eine Spannung zwischen der Drain-Elektrode und der Source-Elektrode des Floating-Gate-Transistors angelegt wird, welcher eine vorgegebene elektrische Ladung, insbesondere Elektronen, speichert, wird kein Kanal gebildet. Deshalb wird ein Strom daran gehindert, durch den Floating-Gate-Transistor zu fließen. Der Floating-Gate-Transistor ist in diesem Fall nichtleitend. Wenn weniger als die vorgegebene elektrische Ladung, insbesondere keine oder beinahe keine Elektronen oder sogar eine positive Ladung, im Floating Gate platziert ist, wird unter dem Gate ein Kanal gebildet und Strom fließt durch den Floating-Gate-Transistor, der in diesem Fall leitend ist.

Das programmierbare Konfigurationselement 9 kann betrieben werden, um einen ersten oder einen zweiten Binärwert zu repräsentieren. Wenn der erste Floating-Gate-Transistor 1 leitend ist und der zweite Floating-Gate-Transistor 2 nichtleitend ist, wird der erste Binärwert repräsentiert. Wenn der zweite Floating-Gate-Transistor 2 leitend ist und der erste Floating-Gate-Transistor 1 nichtleitend ist, wird der zweite Binärwert repräsentiert. Wenn die Speicherzelle nicht benötigt wird, können beide Floating-Gate-Transistoren 1 und 2 nichtleitend geschaltet werden, sodass der Ausgang 3 in einen Zustand mit hoher Impedanz gebracht wird.

In Figur 1 ist der zweite Binärwert repräsentiert, da eine vorgegebene erste Ladung C1 im ersten Floating Gate 13 platziert ist und weniger als die zweite vorgegebene Ladung C2 im zweiten Floating Gate 23 platziert ist.

Während des normalen Betriebsmodus kann das gespeicherte Bit detektiert werden. Um das Bit zu lesen, wird die erste Lesespannung an die erste Leitung Logic-VDD angelegt und die zweite Lesespannung an die zweite Leitung Logic-VSS angelegt. Eine Ausgangsspannung am Ausgang 3 hängt davon ab, ob der erste Floating-Gate-Transistor 1 leitend ist oder der zweite Floating-Gate-Transistor 2 leitend ist. Wenn der erste Floating-Gate-Transistor 1 leitend ist, ist die Ausgangsspannung gleich oder annähernd gleich der ersten Lesespannung. Wenn der zweite Floating-Gate-Transistor 2 leitend ist, ist die Ausgangsspannung gleich oder annähernd gleich der zweiten Lesespannung. Zwischen der ersten Leitung Logic-VDD und der zweiten Leitung Logic-VSS fließt kein Strom, da während des normalen Betriebsmodus entweder der erste Floating-Gate-Transistor 1 oder der zweite Floating-Gate-Transistor 2 nichtleitend ist. Im nicht programmierten zustand können auch beide Floating-Gate-Transistoren nichtleitend sein.

Das Programmieren des zweiten Binärwerts umfasst das Injizieren von Elektronen, um eine vorgegebene Ladung C1 in das erste Floating Gate 13 einzubringen. Als Ergebnis wird der erste Floating-Gate-Transistor 1 nichtleitend. In das zweite Floating Gate 23 wird weniger als eine vorgegebene Ladung C2 eingebracht, wie in Figur 1 dargestellt ist. Der zweite Floating-Gate-Transistor 2 wird dadurch leitend. Das Programmieren des ersten Binärwerts umfasst das Entfernen der Elektronen aus dem ersten Floating Gate 13 und das Injizieren von Elektronen in das zweite Floating Gate 23. Der zweite Floating-Gate-Transistor 2 wird nichtleitend, während der erste Floating-Gate-Transistor 1 leitend wird.

Um Elektronen aus dem ersten Floating Gate 13 zu entfernen, wird eine hohe Spannung, die so genannte erste Schreibspannung, zwischen dem ersten Tunnelelement 15 und dem ersten Steuergate 10 angelegt. Dies verursacht, dass Elektronen durch Fowler-Nordheim-Tunneln aus dem ersten Floating Gate 13 entfernt werden. Der erste Floating-Gate-Transistor 1 wird leitend. Durch Anlegen einer negativen Spannung, der sogenannten zweiten Schreibspannung, zwischen dem ersten Tunnelelement 15 und dem ersten Steuergate 10 werden Elektronen in das erste Floating Gate 13 injiziert. Dadurch wird der erste Floating-Gate-Transistor 1 nichtleitend. Der zweite Floating-Gate-Transistor 2 wird in ähnlicher Weise programmiert, indem die jeweilige erste oder zweite Schreibspannung zwischen dem zweiten Tunnelelement 25 und dem zweiten Steuergate 20 angelegt wird.

Der erste und der zweite Floating-Gate-Transistor 1, 2 halten die Ladung, die das Bit repräsentiert, ohne Leistungsversorgung jahrelang.

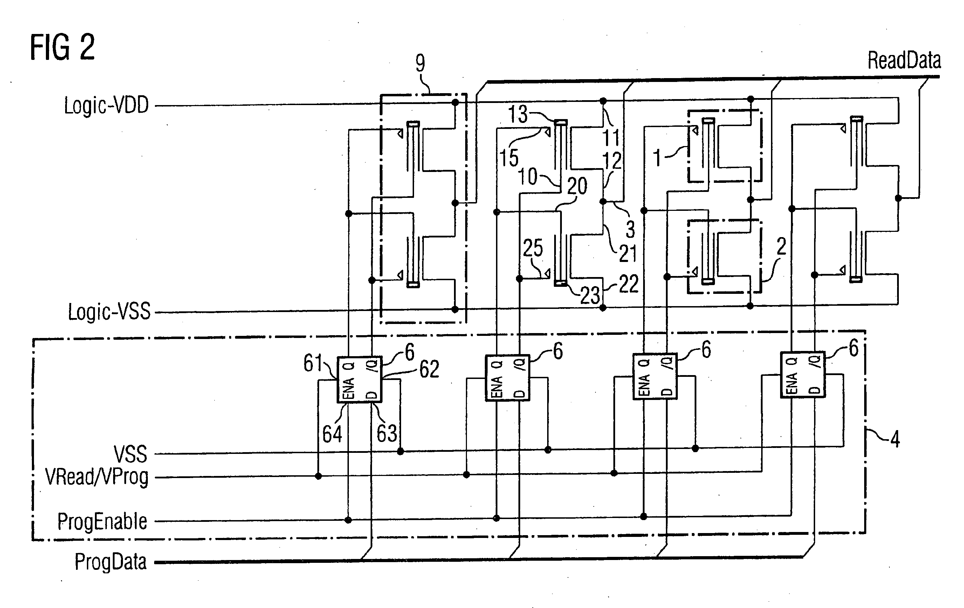

Figur 2 zeigt ein erstes Ausführungsbeispiel einer Anwendung mit mehreren programmierbaren Konfigurationselementen 9 gemäß Figur 1. Jedes programmierbare Konfigurationselement 9 umfasst einen ersten Floating-Gate-Transistor 1 und einen zweiten Floating-Gate-Transistor 2, die in Reihe gekoppelt sind.

Die ersten Anschlüsse 11 der ersten Floating-Gate-Transistoren 1 sind zur Leistungsversorgung mit der ersten Leitung Logic-VDD gekoppelt. Die zweiten Anschlüsse 22 der zweiten Floating-Gate-Transistoren 2 sind mit der zweiten Leitung Logic-VSS gekoppelt.

Der Ausgang 3 jedes programmierbaren Konfigurationselements 9, der zwischen dem ersten Floating-Gate-Transistor 1 und dem zweiten Floating-Gate-Transistor 2 gekoppelt ist, ist mit einer Lesedatenleitung ReadData gekoppelt.

Ferner umfasst das erste Ausführungsbeispiel mehrere erste Pegelumsetzer 6, die jeweils einen ersten und einen zweiten Anschluss 61, 62 umfassen. Der erste Anschluss 61 ist mit einer Lese-/Programmierleitung VRead/VProg gekoppelt, an der während des Programmierbetriebs eine Programmierspannung anliegt oder während des Lesebetriebs eine dritte Lesespannung anliegt. Der zweite Anschluss 62 ist mit einer dritten Leitung VSS gekoppelt, die geerdet ist.

Das erste Ausführungsbeispiel umfasst ferner eine Programmiermodusleitung ProgEnable, an der ein Programmiermodussignal ENA anliegt, das mit einem Moduseingang 64 der ersten Pegelumsetzer 6 gekoppelt ist. Das Programmiermodussignal ENA gibt durch Aktivieren oder Nichtaktivieren des Moduseingangs 64 an, ob der Programmiermodus oder der normale Betriebsmodus vorgesehen ist.

Jeweils eine Programmierdatenleitung ProgData ist mit einem dritten Eingang 63 eines ersten Pegelumsetzers 6 gekoppelt. An jeder Programmierdatenleitung ProgData liegt ein Programmierdatensignal D an, das entweder einen ersten oder einen zweiten zu programmierenden Binärwert repräsentiert. Während des Programmierens ist der Moduseingang 64 der ersten Pegelumsetzer 6 aktiviert. Wenn das Programmierdatensignal D den ersten Binärwert repräsentiert, ist das Datensignal Q gleich der am ersten Anschluss 61 angelegten Programmierspannung, und das inverse Datensignal /Q ist am zweiten Anschluss 62 geerdet. Im Gegensatz dazu ist das inverse Datensignal /Q gleich der Programmierspannung und das Datensignal Q geerdet, wenn das Programmierdatensignal D den zweiten Binärwert repräsentiert.

Jeder Pegelumsetzer 6 stellt durch Koppeln des Datensignals Q mit dem ersten Tunnelelement 15 und dem zweiten Steuergate 20 und durch Koppeln des inversen Datensignals /Q mit dem zweiten Tunnelelement 25 und dem ersten Steuergate 10 die erste und zweite Schreibspannung für eines der vielen programmierbaren Konfigurationselemente 9 bereit.

Während des normalen Betriebsmodus sind die Bits, die in einem programmierbaren Konfigurationselement 9 gespeichert sind, an dessen Ausgang 3 oder der jeweiligen Lesedatenleitung ReadData detektierbar. Am Ausgang 3 liegt die erste Ausgangsspannung an, wenn der erste Binärwert gespeichert ist. In der gleichen Weise ist die zweite Ausgangsspannung detektierbar, wenn der zweite Binärwert gespeichert ist.

Während des normalen Betriebsmodus wird die dritte Lesespannung an den ersten Anschluss 61 der ersten Pegelumsetzer 6 angelegt. Der Moduseingang 64 des ersten Pegelumsetzers 6 ist deaktiviert. Folglich ist sowohl das Datensignal Q als auch das inverse Datensignal /Q gleich der dritten Lesespannung, und hängen sie nicht vom Programmierdatensignal D ab, das an den Pegelumsetzer 6 angelegt ist. Die sich ergebenden Transistorlesespannungen zwischen dem Tunnelelement 15, 25 und dem Steuergate 10, 20 des ersten und zweiten Floating-Gate-Transistors 1, 2 sind null. Während des normalen Betriebsmodus beeinflussen sie die Ladungen, die im ersten und zweiten Floating Gate 13, 23 gespeichert sind, nicht.

Das Lesen der Bits umfasst ferner das Anlegen der ersten Lesespannung an den ersten Anschluss 11 des ersten Floating-Gate-Transistors 1 durch die erste Leitung Logic-VDD und das Anlegen der zweiten Lesespannung an den zweiten Anschluss 22 des zweiten Floating-Gate-Transistors 2 durch die zweite Leitung Logic-VSS. Die erste Lesespannung dient zur Versorgung. Die zweite Lesespannung kann geerdet sein.

Die erste Lesespannung kann am Ausgang 3 detektiert werden, wenn ein erster Binärwert gespeichert ist, und die zweite Lesespannung kann detektiert werden, wenn ein zweiter Binärwert gespeichert ist. Die erste Spannung repräsentiert den ersten Binärwert, und die zweite Spannung repräsentiert den zweiten Binärwert. Beide Spannungen sind mit den Logiksignalen, die in nicht-speicherrelevanten Teilen der Vorrichtung verwendet werden, welche direkt mit den Lesedatenleitungen ReadData gekoppelt sein können, kompatibel. Alternativ kann ein Puffer oder dergleichen zwischen den Speicherzellen und den Lesedatenleitungen ReadData gekoppelt sein. Die nicht-speicherrelevante Teile sind in den Figuren nicht dargestellt.

Während der Durchführung des Programmierens wird die Lese-/Programmierleitung VRead/VProg auf die Programmierspannung gezogen, die höher als die dritte Lesespannung ist, und der Moduseingang 64 des ersten Pegelumsetzers 6 wird aktiviert. Deshalb können die Spannungen, die durch den ersten Pegelumsetzer 6 am ersten bzw. zweiten Tunnelelement 15, 25 und am ersten bzw. zweiten Steuergate 10, 20 anliegen, die Ladung im ersten und zweiten Floating Gate 13, 23 beeinflussen. Diese Spannungen umfassen eine erste und eine zweite Schreibspannung. Die erste und die zweite Lesespannung, die an die erste bzw. die zweite Leitung Logic-VDD, Logic-VSS, angelegt werden, müssen während des Programmierbetriebs nicht verändert werden. Das Anlegen der Programmierspannung an die Tunnelelemente und das Erden der Steuergates führt zum Anlegen der ersten Schreibspannung zwischen den Tunnelelementen und den Steuergates. Die zweite Schreibspannung wird angelegt, wenn das Tunnelelement geerdet ist und die Programmierspannung an das Steuergate angelegt ist.

Wenn die erste Schreibspannung über das erste Tunnelelement 15 und das erste Steuergate 10 angelegt wird und die zweite Schreibspannung über das zweite Tunnelelement 25 und das zweite Steuergate 20 angelegt wird, wird eine elektrische Ladung in das zweite Floating Gate 23 injiziert und gespeichert und aus dem ersten Floating Gate 13 entfernt, um den ersten Binärwert zu repräsentieren. Wenn die zweite Schreibspannung über das erste Tunnelelement 15 und das erste Steuergate 10 angelegt wird und die erste Schreibspannung über das zweite Tunnelelement 25 und das zweite Steuergate 20 angelegt wird, wird dadurch der zweite Binärwert programmiert.

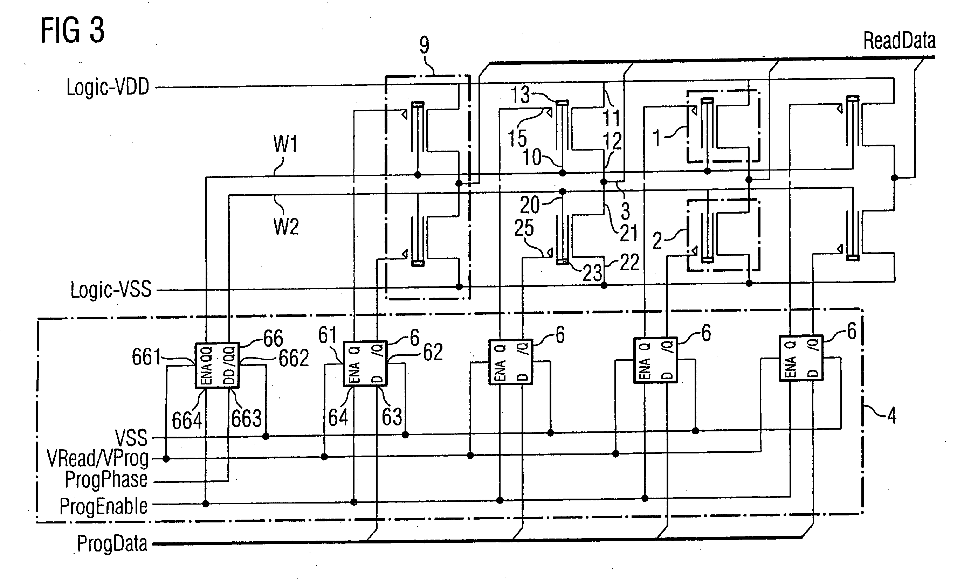

Figur 3 zeigt das zweite Ausführungsbeispiel einer Anwendung, die mehrere programmierbare Konfigurationselemente 9 gemäß Figur 2 umfasst. Jedes programmierbare Konfigurationselement 9 umfasst einen ersten Floating-Gate-Transistor 1 und einen zweiten Floating-Gate-Transistor 2, die in Reihe gekoppelt sind.

Der erste Anschluss 11 des ersten Floating-Gate-Transistors 1 ist zur Leistungsversorgung mit der ersten Leitung Logic-VDD gekoppelt. Der zweite Anschluss 22 des zweiten Floating-Gate-Transistors 2 ist mit der zweiten Leitung Logic-VSS gekoppelt, die geerdet ist.

Der Ausgang 3 jedes programmierbaren Konfigurationselements 9, der zwischen dem ersten Floating-Gate-Transistor 1 und dem zweiten Floating-Gate-Transistor 2 gekoppelt ist, ist mit einer Lesedatenleitung ReadData gekoppelt.

Ähnlich wie in Figur 2 umfasst die zweite Ausführungsform mehrere erste Pegelumsetzer 6. Die ersten Pegelumsetzer 6 sind wie oben beschrieben mit der geerdeten dritten Leitung VSS, der Lese-/Programmierleitung VRead/VProg, dem Programmiermodussignal ENA und den Programmierdatenleitungen ProgData gekoppelt.

Doch das Datensignal Q und das inverse Datensignal /Q des ersten Pegelumsetzers 6 sind auf eine andere Weise mit dem ersten und dem zweiten Floating-Gate-Transistor 1, 2 des jeweiligen programmierbaren Konfigurationselements 9 gekoppelt. Das Datensignal Q ist nur mit dem ersten Tunnelelement 15 gekoppelt, und das inverse Datensignal /Q ist nur mit dem zweiten Tunnelelement 25 gekoppelt. Die sich ergebenden Unterschiede zu Figur 2 werden im Folgenden beschrieben.

Das zweite Ausführungsbeispiel umfasst ferner einen zweiten Pegelumsetzer 66 mit einem ersten Anschluss 661, der mit der Lese-/Programmierleitung VRead/VProg gekoppelt ist, und mit einem zweiten Anschluss 662, der mit der geerdeten dritten Leitung VSS gekoppelt ist. Der zweite Pegelumsetzer 66 umfasst ferner einen dritten Anschluss 663, der mit einem Programmierphasensignal DD gekoppelt ist, das durch eine Programmierphasenleitung ProgPhase bereitgestellt wird. Ein Moduseingang 664 ist mit dem Programmiermodussignal ENA gekoppelt. Der zweite Pegelumsetzer 66 stellt auf die gleiche Weise, in der das Datensignal Q und das inverse Datensignal /Q durch die ersten Pegelumsetzer 6 bereitgestellt werden, ein zweites Datensignal QQ und ein zweites inverses Datensignal /QQ bereit. Das zweite Datensignal QQ und das zweite inverse Datensignal /QQ hängen beide in der entsprechende Weise vom Programmierphasensignal DD und vom Programmiermodussignal ENA ab, wie das Datensignal Q und das inverse Datensignal /Q vom Programmierdatensignal D und vom Programmiermodussignal ENA abhängen.

Das zweite Datensignal QQ ist durch eine erste Wortleitung W1 mit dem ersten Steuergate 10 gekoppelt. Das zweite inverse Datensignal /QQ ist durch eine zweite Wortleitung W2 mit dem zweiten Steuergate 20 gekoppelt. Als Ergebnis hängen die Programmier- und Lesespannungen, die an das erste und zweite Steuergate 10, 20 und an das erste und zweite Tunnelelement 15, 25 eines programmierbaren Konfigurationselements 9 angelegt werden, von der Wechselwirkung der jeweiligen ersten Pegelumsetzer 6 und des zweiten Pegelumsetzers 66 ab.

Wegen der ersten und zweiten Wortleitung W1 und W2 und der einfacheren Verdrahtung zwischen den ersten Pegelumsetzern 6 und den programmierbaren Konfigurationselementen 9 benötigt das zweite Ausführungsbeispiel nach Figur 3 weniger Platz als das erste Ausführungsbeispiel nach Figur 2, wenn mehr als nur einige, wenige Bits speicherbar sein sollen.

Während des normalen Betriebsmodus werden die erste und die zweite Lesespannung an die erste und die zweite Leitung Logic-VDD und Logic-VSS angelegt. Die dritte Lesespannung wird an die Lese-/Programmierleitung VRead/VProg angelegt, während die Moduseingänge 64, 664 des ersten und zweiten Pegelumsetzers 6, 66 deaktiviert sind. Die sich ergebenden Spannungen, die zwischen den ersten bzw. zweiten Tunnelelementen 15, 25 und den ersten bzw. zweiten Steuergates 10, 20 angelegt sind, sind null und beeinflussen die Ladung, die im programmierbaren Konfigurationselement 9 gespeichert ist, nicht.

Während des Programmierens wird an die Lese-/Programmierleitung VRead/VProg die Programmierspannung angelegt. Das Programmieren des programmierbaren Konfigurationselements 9 im zweiten Ausführungsbeispiel umfasst zwei Hauptschritte. Entweder der erste oder der zweite Binärwert wird zuerst programmiert, danach wird der andere programmiert.

Ein Programmierschritt umfasst das Programmieren des zweiten Binärwerts. Das Programmierphasensignal wird gewählt, sodass durch das zweite Datensignal QQ die Programmierspannung bereitgestellt wird und das zweite inverse Datensignal /QQ geerdet wird.

Wenn der zweite Binärwert programmiert wird, stellt der entsprechende erste Pegelumsetzer 6 die Programmierspannung durch das inverse Datensignal /Q bereit und das Datensignal Q wird geerdet. Folglich wird die zweite Schreibspannung zwischen dem ersten Tunnelelement 15 und dem ersten Steuergate 10 angelegt und die erste Schreibspannung wird zwischen dem zweiten Tunnelelement 25 und dem zweiten Steuergate 20 angelegt. Elektronen werden in das erste Floating Gate 13 injiziert, der erste Floating-Gate-Transistor 1 wird nichtleitend, und Elektronen werden aus dem zweiten Floating Gate 23 entfernt, der zweite Floating-Gate-Transistor 2 wird leitend.

Wenn der erste Pegelumsetzer 6 die Programmierspannung durch das Datensignal Q bereitstellt und das inverse Datensignal /Q geerdet wird, um den ersten Binärwert zu programmieren, während die Programmierspannung durch das zweite Datensignal QQ bereitgestellt wird und das zweite inverse Datensignal /QQ geerdet wird, sind die sich ergebenden Spannungen zwischen dem ersten Tunnelelement 15 und dem ersten Steuergate 10 und dem zweiten Tunnelelement 25 und dem zweiten Steuergate 20 null. Die Ladung im ersten und im zweiten Floating Gate wird während dieses Schritts nicht verändert.

Der andere Programmierschritt umfasst das Erden des zweiten Datensignals QQ und das Setzen des zweiten inversen Datensignals /QQ gleich der Programmierspannung, indem das Programmierphasensignal verändert wird. Die Datensignale Q und die inversen Datensignale /Q, die durch die ersten Pegelumsetzer 6 bereitgestellt werden, werden nicht verändert. Als Ergebnis wird der erste Binärwert programmiert.

Wenn der erste Binärwert programmiert werden soll, stellt der entsprechende erste Pegelumsetzer 6 die Programmierspannung durch das Datensignal Q bereit und wird das inverse Datensignal /Q geerdet, während die Programmierspannung durch das zweite inverse Datensignal /QQ bereitgestellt wird und das zweite Datensignal QQ geerdet ist. Aufgrund der sich ergebenden Spannungen zwischen dem ersten Tunnelelement 15 und dem ersten Steuergate 10 und dem zweiten Tunnelelement 25 und dem zweiten Steuergate 20 werden Elektronen in das zweite Floating Gate 23 injiziert. Der zweite Floating-Gate-Transistor 2 wird nichtleitend. Es werden Elektronen aus dem ersten Floating Gate 13 entfernt. Der erste Floating-Gate-Transistor 1 wird leitend.

Wenn der zweite Binärwert in das programmierbare Konfigurationselement 9 zu programmieren ist, wird die Ladung im ersten und zweiten Floating Gate während dieses Programmierschritts nicht verändert.

In den oben beschriebenen Ausführungsformen ist der nichtflüchtige Speicher eine Floating-Gate-Zelle. Es versteht sich jedoch, dass andere nichtflüchtige Speicherzellen verwendet werden könnten. Zum Beispiel entkoppelt ein Aspekt der vorliegenden Erfindung die Versorgung mit Hochspannungen (VDD, VSS) und die Versorgung mit Niederspannungen (Logic-VDD, Logic-VSS). Die Lesespannungen werden an Anschlüssen des ersten und zweiten Floating-Gate-Transistors angelegt. Lesespannungen, die mit dem ersten und dem zweiten Floating-Gate-Transistor gekoppelt sind, müssen nicht entkoppelt werden, um Schreibspannungen anzulegen. Der erste und zweite Floating-Gate-Transistor kann programmiert werden, indem Hochspannungen an sein Tunnelelement und sein Steuergate angelegt werden, während die Lesespannungen nach wie vor an den ersten und den zweiten Anschluss angelegt sind. Während des Lesemodus werden die Hochspannungen nicht angelegt. In dieser Ausführungsform könnten jegliche beliebigen nichtflüchtigen Speicherzellen, die in einer ähnlichen Weise programmiert und gelesen werden können, verwendet werden.

Es sei bemerkt, dass die vorliegende Erfindung viele anwendbare Konzepte bereitstellt, die in vielen Zusammenhängen angewandt werden können. Die besprochenen Ausführungsbeispiele sind nur Beispiele, die Erfindung auszuführen und zu verwenden, erläuternd und beschränken den Umfang der Erfindung jedoch nicht.

### Bezugszeichenliste

- 9: programmierbares Konfigurationselement
- 3: Ausgang
- 1: erster Floating-Gate-Transistor
- 11: erster Anschluss des ersten Floating-Gate-Transistors
- 12: zweiter Anschluss des ersten Floating-Gate-Transistors
- 13: erstes Floating Gate
- 10: erstes Steuergate
- 15: erstes Tunnelelement
- 2: zweiter Floating-Gate-Transistor
- 21: erster Anschluss des zweiten Floating-Gate-Transistors
- 22: zweiter Anschluss des zweiten Floating-Gate-Transistors
- 23: zweites Floating Gate
- 20: zweites Steuergate
- 25: zweites Tunnelelement
- 4: Programmierschaltung
- 6: erster Pegelumsetzer
- 61: erster Anschluss des ersten Pegelumsetzers
- 62: zweiter Anschluss des ersten Pegelumsetzers
- 63: dritter Anschluss des ersten Pegelumsetzers
- 64: Moduseingang des ersten Pegelumsetzers
- 66: zweiter Pegelumsetzer
- 661: erster Anschluss des zweiten Pegelumsetzers
- 662: zweiter Anschluss des zweiten Pegelumsetzers
- 663: dritter Anschluss des zweiten Pegelumsetzers
- 664: Moduseingang des zweiten Pegelumsetzers
- Logic-VVD erste Leitung:
- Logic-VSS zweite Leitung:
- VSS: dritte Leitung
- VRead/VProg: Lese-/Programmierleitung
- ProgEnable: Programmiermodussignalleitung
- ProgData: Programmierdatenleitung
- ProgPhase: Programmierphasenleitung
- ReadData: Lesedatenleitung

- D: Programmieraacensignai
- Q: Datensignal
- /Q: inverses Datensignal
- QQ: zweites Datensignal
- /QQ: zweites inverses Datensignal
- DD: Programmierphasensignal
- ENA: Programmiermodussignal
- C1: erste vorgegebene elektrische Ladung
- C2: zweite vorgegebene elektrische Ladung

## Patentansprüche

1. Halbleiterschaltungsvorrichtung umfassend ein programmierbares Konfigurationselement (9) mit
- einer ersten nichtflüchtigen Speicherzelle (1) mit einem Strompfad zwischen einem ersten Anschluss (11) und einem zweiten Anschluss (12), die in einen ersten Zustand, in dem der Strompfad im Wesentlichen leitend ist, oder in einen zweiten Zustand, in dem der Strompfad im Wesentlichen nichtleitend ist, konfigurierbar ist;
- einer zweiten nichtflüchtigen Speicherzelle (2) mit einem Strompfad zwischen einem ersten Anschluss (21) und einem zweiten Anschluss (22), die in den ersten Zustand oder in den zweiten Zustand konfigurierbar ist, wobei der zweite Anschluss (12) der ersten nichtflüchtigen Speicherzelle (1) mit dem ersten Anschluss (21) der zweiten nichtflüchtigen Speicherzelle (2) gekoppelt ist;
- einem ersten Logikpegelknoten (Logic-VDD), der mit dem ersten Anschluss (11) der ersten nichtflüchtigen Speicherzelle (1) gekoppelt ist;
- einem zweiten Logikpegelknoten (Logic-VSS), der mit dem zweiten Anschluss (22) der zweiten nichtflüchtigen Speicherzelle (2) gekoppelt ist; und
- einem Ausgang (3), der mit dem zweiten Anschluss (12) der ersten nichtflüchtigen Speicherzelle (1) und dem ersten Anschluss (21) der zweiten nichtflüchtigen Speicherzelle (2) gekoppelt ist;
wobei der Ausgang (3) mit dem ersten Logikpegelknoten gekoppelt (Logic-VDD) ist, wenn sich die erste nichtflüchtige Speicherzelle (1) im ersten Zustand befindet;
wobei der Ausgang (3) mit dem zweiten Logikpegelknoten (Logic-VSS) gekoppelt ist, wenn sich die zweite nichtflüchtige Speicherzelle (2) im ersten Zustand befindet; und
wobei die Halbleiterschaltungsvorrichtung derartig betreibbar ist, dass sich die erste nichtflüchtige Speicherzelle (1) nicht gleichzeitig mit der zweiten nichtflüchtigen Speicherzelle (2) im ersten Zustand befindet.

2. Halbleiterschaltungseinrichtung nach Anspruch 1, die derartig betreibbar ist, dass sich die erste nichtflüchtige Speicherzelle (1) zur gleichen Zeit im ersten Zustand befindet, zu der sich die zweite nichtflüchtige Speicherzelle (2) im zweiten Zustand befindet, oder dass sich die erste nichtflüchtige Speicherzelle (1) zur gleichen Zeit im zweiten Zustand befindet, zu der sich die zweite nichtflüchtige Speicherzelle (2) im ersten Zustand befindet.

3. Halbleiterschaltungsvorrichtung nach Anspruch 1 oder 2,
wobei die erste nichtflüchtige Speicherzelle (1) einen ersten Floating-Gate-Transistor umfasst und die zweite nichtflüchtige Speicherzelle (2) einen zweiten Floating-Gate-Transistor umfasst.

4. Halbleiterschaltungsvorrichtung nach Anspruch 3 mit einer Programmierschaltung (4), die mit dem ersten Floating-Gate-Transistor (1) und dem zweiten Floating-Gate-Transistor (2) gekoppelt ist, wobei die Programmierschaltung (4) betreibbar ist, um eine erste vorgegebene elektrische Ladung (C1) in ein erstes Floating Gate (13) des ersten Floating-Gate-Transistors (1) zu positionieren und eine geringere Ladung als eine vorgegebene zweite elektrische Ladung (C2) in ein zweites Floating Gate (23) des zweiten Floating-Gate-Transistors
(2) zu positionieren, oder betreibbar ist, um eine geringere Ladung als die erste vorgegebene elektrische Ladung (C1) in das erste Floating Gate (13) zu positionieren und die zweite vorgegebene elektrische Ladung (C2) in das zweite Floating Gate (23) zu positionieren.

5. Halbleiterschaltungsvorrichtung nach Anspruch 4, wobei der erste Floating-Gate-Transistor (1) leitend ist, wenn eine geringere Ladung als die erste vorgegebene elektrische Ladung (C1) im ersten Floating Gate (13) positioniert ist, oder der erste Floating-Gate-Transistor (1) nichtleitend ist, wenn die erste vorgegebene elektrische Ladung (C1) im ersten Floating Gate (13) positioniert ist;
und der zweite Floating-Gate-Transistor (2) leitend ist, wenn eine geringere Ladung als die zweite vorgegebene elektrische Ladung (C2) im zweiten Floating Gate (23) positioniert ist, oder der zweite Floating-Gate-Transistor (2) nichtleitend ist, wenn die zweite vorgegebene elektrische Ladung (C2) im zweiten Floating Gate (23) positioniert ist.

6. Halbleiterschaltungsvorrichtung nach einem der Ansprüche 3 bis 5, wobei der erste Floating-Gate-Transistor (1) ein erstes Steuergate (10) und ein erstes Tunnelelement (15) umfasst, und der zweite Floating-Gate-Transistor (2) ein zweites Steuergate (20) und ein zweites Tunnelelement (25) umfasst.

7. Halbleiterschaltungsvorrichtung nach einem der Ansprüche 1 bis 6, die eine Programmierdatenleitung (ProgData) mit einem Programmierdatensignal (D) umfasst, das einen ersten oder zweiten Binärwert repräsentiert, und wobei die Programmierdatenleitung (ProgData) mit der Programmierschaltung (4) gekoppelt ist.

8. Halbleiterschaltungsvorrichtung nach einem der Ansprüche 1 bis 7, wobei eine Vielzahl von programmierbaren Konfigurationselementen (9) vorgesehen sind und die Programmierschaltung (4) mit mindestens einem der Vielzahl der programmierbaren Konfigurationselemente (9) gekoppelt ist.

9. Halbleiterschaltungsvorrichtung nach Anspruch 8, die eine Vielzahl von Programmierdatenleiturigen (ProgData) mit jeweils einem Programmierdatensignal (D), das den ersten oder zweiten Binärwert repräsentiert, umfasst, wobei die Programmierdatenleitungen (ProgData) mit der Programmierschaltung (4) gekoppelt sind.

10. Halbleiterschaltungsvorrichtung nach Anspruch 8 oder 9,
wobei eine erste Leitung (Logic-VDD) mit den ersten Logikpegelknoten der programmierbaren Konfigurationselemente (9) gekoppelt ist, und eine zweite Leitung (Logic-VSS) mit den zweiten Logikpegelknoten der programmierbaren Konfigurationselemente (9) gekoppelt ist.

11. Halbleiterschaltungsvorrichtung nach einem der Ansprüche 4 bis 10, wobei die Programmierschaltung (4) mindestens ein Datensignal (Q) und mindestens ein inverses Datensignal (/Q) bereitstellt, wobei das Datensignal (D) mit dem ersten Steuergate (10) und dem zweiten Tunnelelement (25), das inverse Datensignal (/D) mit dem zweiten Steuergate (20) und dem ersten Tunnelelement (15) eines der programmierbaren Konfigurationselemente (9) gekoppelt ist.

12. Halbleiterschaltungsvorrichtung nach Anspruch 11, wobei die Programmierschaltung (4) umfasst:
- eine Lese-/Programmierleitung (VRead/VProg);
- eine dritte Leitung (VSS);
- eine Programmiermodussignalleitung (ProgEnable); und
- mindestens einen ersten Pegelumsetzer (6), der das Datensignal (Q) und das inverse Datensignal (/Q) bereitstellt, mit einem ersten Anschluss (61), der mit der Lese-/Programmierleitung (VRead/VProg) gekoppelt ist, einem zweiten Anschluss (62), der mit der dritten Leitung (VSS) gekoppelt ist, einem dritten Anschluss (63), der mit der Programmierdatenleitung (ProgData) gekoppelt ist, und einen aktivierbaren Moduseingang (64), der mit der Programmiermodussignalleitung (ProgEnable) gekoppelt ist.

13. Halbleiterschaltungsvorrichtung nach Anspruch 12, wobei, wenn der Moduseingang (64) des ersten Pegelumsetzers (6) aktiviert ist und das Programmierdatensignal (D) den ersten Binärwert repräsentiert, das Datensignal (Q) einen Spannungswert annimmt, der am ersten Anschluss (61) des ersten Pegelumsetzers (6) anliegt, und das inverse Datensignal (/Q) einen Spannungswert annimmt, der am zweiten Anschluss (62) des ersten Pegelumsetzers (6) anliegt; oder
wenn der Moduseingang (64) des ersten Pegelumsetzers (6) aktiviert ist und das Programmierdatensignal (D) den zweiten Binärwert repräsentiert, das inverse Datensignal (/Q) den Spannungswert annimmt, der am ersten Anschluss (61) des ersten Pegelumsetzers (6) anliegt, und das Datensignal (Q) den Spannungswert annimmt, der am zweiten Anschluss (62) des ersten Pegelumsetzers (6) anliegt; oder
wenn der Moduseingang (64) des ersten Pegelumsetzers (6) nicht aktiviert ist, das Datensignal (Q) und das inverse Datensignal (/Q) den Spannungswert annehmen, der am ersten Anschluss (61) des ersten Pegelumsetzers (6) anliegt.

14. Halbleiterschaltungsvorrichtung nach einem der Ansprüche 8 bis 13 mit
- einer Programmierphasenleitung (ProgPhase) mit einem Programmierphasensignal (DD), das den ersten oder zweiten Binärwert repräsentiert; und
- einem zweiten Pegelumsetzer (66), der ein zweites Datensignal (QQ) und ein zweites inverses Datensignal (/QQ) bereitstellt, mit einem ersten Anschluss (661), der mit der Lese-/Programmierleitung (VRead/VProg) gekoppelt ist, einem zweiten Anschluss (662), der mit der dritten Leitung (VSS) gekoppelt ist, einem dritten Anschluss (663), der mit der Programmierphasenleitung (ProgPhase) gekoppelt ist, und einen aktivierbaren Moduseingang (664), der mit der Programmiermodussignalleitung (ProgEnable) gekoppelt ist.

15. Halbleiterschaltungsvorrichtung nach Anspruch 14, wobei, wenn der Moduseingang (664) des zweiten Pegelumsetzers (66) aktiviert ist und das Programmierphasensignal (DD) den ersten Binärwert repräsentiert, das zweite Datensignal (QQ) einen Spannungswert annimmt, der am ersten Anschluss (661) des zweiten Pegelumsetzers (66) anliegt, und das zweite inverse Datensignal (/QQ) einen Spannungswert annimmt, der am zweiten Anschluss (662) des zweiten Pegelumsetzers (66) anliegt; oder
wenn der Moduseingang (664) des zweiten Pegelumsetzers (66) aktiviert ist und das Programmierphasensignal (DD) den zweiten Binärwert repräsentiert, das zweite inverse Datensignal (/QQ) den Spannungswert annimmt, der am ersten Anschluss (661) des zweiten Pegelumsetzers (66) anliegt, und das zweite Datensignal (QQ) den Spannungswert annimmt, der am zweiten Anschluss (662) des zweiten Pegelumsetzers (66) anliegt; oder
wenn der Moduseingang (664) des zweiten Pegelumsetzers (66) nicht aktiviert ist, das zweite Datensignal (QQ) und das zweite inverse Datensignal (/QQ) den Spannungswert annehmen, der am ersten Anschluss (661) des zweiten Pegelumsetzers (66) anliegt.

16. Halbleiterschaltungsvorrichtung nach Anspruch 15, wobei einer der ersten Pegelumsetzer (6) derart mit einem der programmierbaren Konfigurationselemente gekoppelt ist, dass das Datensignal (Q) mit dem ersten Tunnelelement (15) gekoppelt ist, das inverse Datensignal (/Q) mit dem zweiten Tunnelelement (25) gekoppelt ist, das zweite Datensignal (QQ) mit dem ersten Steuergate (10) gekoppelt ist, und das zweite inverse Datensignal (/QQ) mit dem zweiten Steuergate (20) gekoppelt ist.

17. Verfahren zum Betreiben einer Halbleiterschaltungsvorrichtung nach einem der Ansprüche 1 bis 16 umfassend
Programmieren eines Bits mit einem ersten Binärwert durch Anlegen von Schreibspannungen an die erste nichtflüchtige Speicherzelle (1) und die zweite nichtflüchtige Speicherzelle (2), sodass die erste nichtflüchtige Speicherzelle leitend wird und die zweite nichtflüchtige Speicherzelle nichtleitend wird, oder
mit einem zweiten Binärwert, sodass die erste nichtflüchtige Speicherzelle (1) nichtleitend wird und die zweite nichtflüchtige Speicherzelle (2) leitend wird; oder
Lesen des programmierten Bits am Ausgang (3).

18. Verfahren nach Anspruch 17, wobei das Anlegen der Schreibspannungen an das erste Steuergate (10), das erste Tunnelelement (15), das zweite Steuergate (20), das zweite Tunnelelement (25), den ersten Anschluss (11) des ersten Floating-Gate-Transistors (1) und den zweiten Anschluss (22) des zweiten Floating-Gate-Transistors (2) umfasst.

19. Verfahren nach Anspruch 17 oder 18, wobei das Lesen des programmierten Bits das Anlegen von Lesespannungen an das erste Steuergate (10), das erste Tunnelelement (15), das zweite Steuergate (20), das zweite Tunnelelement (15), den ersten Anschluss (11) des ersten Floating-Gate-Transistors (1) und den zweiten Anschluss (22) des zweiten Floating-Gate-Transistors (2) umfasst.

20. Verfahren nach Anspruch 17 oder 18, wobei das Anlegen der Schreibspannungen umfasst:
Anlegen einer ersten Spannung an den ersten Anschluss (11) des ersten Floating-Gate-Transistors (1); und
Anlegen einer zweiten Spannung an den zweiten Anschluss (22) des zweiten Floating-Gate-Transistors (2).

21. Verfahren nach Anspruch 20, wobei das Anlegen der Schreibspannungen zum Programmieren des ersten Binärwerts umfasst:
Anlegen einer ersten Schreibspannung zwischen dem ersten Tunnelelement (15) und dem ersten Steuergate (10); und
Anlegen einer zweiten Schreibspannung zwischen dem zweiten Tunnelelement (25) und dem zweiten Steuergate (20);
wobei das Anlegen der Schreibspannungen zum Programmieren des zweiten Binärwerts umfasst:
Anlegen der zweiten Schreibspannung zwischen dem ersten Tunnelelement (15) und dem ersten Steuergate (10); und
Anlegen der ersten Schreibspannung zwischen dem zweiten Tunnelelement (25) und dem zweiten Steuergate (20).

22. Verfahren nach Anspruch 20, wobei das Anlegen der Schreibspannungen zum Programmieren des ersten Binärwerts die Schritte umfasst:
Anlegen einer ersten Schreibspannung zwischen dem ersten Tunnelelement (15) und dem ersten Steuergate (10);
Anlegen einer zweiten Schreibspannung zwischen dem zweiten Tunnelelement (25) und dem zweiten Steuergate (20);
Anlegen einer dritten Schreibspannung zwischen dem ersten Tunnelelement (15) und dem ersten Steuergate (10); und
Anlegen einer vierten Schreibspannung zwischen dem zweiten Tunnelelement (25) und dem zweiten Steuergate (20);
wobei das Anlegen der Schreibspannungen zum Programmieren des zweiten Binärwerts die Schritte umfasst:
Anlegen der vierten Schreibspannung zwischen dem ersten Tunnelelement (15) und dem ersten Steuergate (10);
Anlegen der dritten Schreibspannung zwischen dem zweiten Tunnelelement (25) und dem zweiten Steuergate (20);
Anlegen der zweiten Schreibspannung zwischen dem ersten Tunnelelement (15) und dem ersten Steuergate (10); und
Anlegen der ersten Schreibspannung zwischen dem zweiten Tunnelelement (25) und dem zweiten Steuergate (20).

23. Verfahren nach Anspruch 20, wobei das Anlegen der Schreibspannungen zum Programmieren des ersten Binärwerts die Schritte umfasst:
Anlegen der dritten Schreibspannung zwischen dem ersten Tunnelelement (15) und dem ersten Steuergate (10);
Anlegen der vierten Schreibspannung zwischen dem zweiten Tunnelelement (25) und dem zweiten Steuergate (20);
Anlegen der ersten Schreibspannung zwischen dem ersten Tunnelelement (15) und dem ersten Steuergate (10); und
Anlegen der zweiten Schreibspannung zwischen dem zweiten Tunnelelement (25) und dem zweiten Steuergate (20);
wobei das Anlegen der Schreibspannungen zum Programmieren des zweiten Binärwerts die Schritte umfasst:
Anlegen der zweiten Schreibspannung zwischen dem ersten Tunnelelement (15) und dem ersten Steuergate (10);
Anlegen der ersten Schreibspannung zwischen dem zweiten Tunnelelement (25) und dem zweiten Steuergate (20);
Anlegen der vierten Schreibspannung zwischen dem ersten Tunnelelement (15) und dem ersten Steuergate (10); und
Anlegen der dritten Schreibspannung zwischen dem zweiten Tunnelelement (25) und dem zweiten Steuergate (20).

24. Verfahren nach Anspruch 22 oder 23, wobei die dritte Schreibspannung und die vierte Schreibspannung gleich oder annähernd gleich sind.

25. Verfahren nach Anspruch 19, wobei das Anlegen der Lesespannungen umfasst:
Anlegen der ersten Spannung an den ersten Anschluss (11) des ersten Floating-Gate-Transistors (1); und
Anlegen der zweiten Spannung an den zweiten Anschluss (22) des zweiten Floating-Gate-Transistors (2).

26. Verfahren nach Anspruch 25, wobei das Anlegen der Lesespannungen umfasst:
Anlegen einer ersten Transistorlesespannung zwischen dem ersten Tunnelelement (15) und dem ersten Steuergate (10); und
Anlegen einer zweiten Transistorlesespannung zwischen dem zweiten Tunnelelement (25) und dem zweiten Steuergate (20).

27. Verfahren nach Anspruch 26, wobei die erste Transistorlesespannung und die zweite Transistorlesespannung gleich oder annähernd gleich sind.

28. Verfahren nach Anspruch 27, wobei die erste Transistorlesespannung und die zweite Transistorlesespannung null oder annähernd null sind.
